# EUROPÄISCHE PATENTSCHRIFT

(11) **EP 1 169 736 B1**
(45) Veröffentlichungstag und Bekanntmachung des Hinweises auf die Patenterteilung: **12.07.2006**
(21) Anmeldenummer: 00915126.7
(22) Anmeldetag: 01.03.2000
(51) Int. Cl.: H01L 25/07

(54) **LEISTUNGSHALBLEITERMODUL**
POWER SEMICONDUCTOR MODULE
MODULE A SEMICONDUCTEUR DE PUISSANCE

(30) Priorität: 17.03.1999 DE 19911953
(43) Veröffentlichungstag der Anmeldung: 09.01.2002
(73) Patentinhaber: eupec Europäische Gesellschaft für Leistungshalbleiter mbH & Co. KG, 59581 Warstein-Belecke (DE)
(72) Erfinder: FERBER, Gottfried, D-59581 Warstein (DE); PELMER, Reimund, D-59494 Soest (DE)
(74) Vertreter: Schmuckermaier, Bernhard
(86) Internationale Anmeldenummer: PCT/DE2000/000595
(87) Internationale Veröffentlichungsnummer: WO 2000/055917

(56) Entgegenhaltungen:
- EP-A- 0 513 410
- EP-A- 0 588 094
- EP-A- 0 609 528
- EP-A- 0 716 450
- EP-A- 0 772 235
- EP-A- 0 884 781

## Beschreibung

Die Erfindung betrifft ein Leistungshalbleitermodul bestehend aus:
- Einem Kunststoffgehäuse,
- mehreren Anschlußelementen für äußere Haupt- und Steueranschlüsse,
- zumindest einem Keramiksubstrat, das zumindest auf seiner Oberfläche mit einer strukturierten Metallisierung versehen und mit Halbleiterbauelementen bestückt ist und in die Bodenöffnung des Kunststoffgehäuses eingesetzt ist.

Ein solches Leistungshalbleitermodul ist seit langer Zeit bekannt und beispielsweise in der DE 36 04 313 A1 eingehend beschrieben.

Die bei diesen Leistungshalbleitermodulen verwendeten Keramiksubstrate bestehen üblicherweise aus Aluminiumoxid Al₂O₃ oder AlN und sind mit lötfähigen Leiterbahnen, d. h. einer strukturierten Metallisierung versehen.

Bei den aus Aluminiumoxid bestehenden Keramiksubstraten werden diese Leiterbahnen über das sogenannte Direct-Copper-Bonding-Verfahren hergestellt, wo hingegen bei denen aus Aluminiumnitrid bestehenden Keramiksubstraten die Leiterbahnen über das Active-Metal-Brazing-Verfahren hergestellt werden. Beide Verfahren sind hinlänglich im Stand der Technik beschrieben.

Auf diese lötfähigen Leiterbahnen werden die Last- und Steueranschlüsse als Metallwinkel, Kopfdrähte oder Stanzbiegeteile stumpf auf die vorgesehenen Anschlußflächen weichgelötet. Zum Ausgleich von auftretenden Zug- und Biegebelastungen sind in den Last- und Steueranschlüssen beispielsweise Ausgleichsbögen vorgesehen. Die so erzielten Verbindungen weisen des öfteren jedoch Probleme bezüglich der mechanischen Zuverlässigkeit der Verbindungen auf.

Ferner fordert die Verwendung von Last- und Steueranschlüssen mit Ausgleichsbögen einen größeren Platzbedarf, so daß einer Miniaturisierung der Leistungshalbleitermodule Grenzen gesetzt sind.

Über die Außenkanten der Keramiksubstrate ragende Anschlußlaschen werden in der Regel mit Anschlußsteckern oder Lastanschlüssen verschweißt oder gelötet.

Aufgabe der vorliegenden Erfindung ist es daher, ein Leistungshalbleitermodul der eingangs genannten Art bereitzustellen, welches eine erhöhte mechanische Zuverlässigkeit in den Verbindungen der Lastanschlüsse und/oder der Steueranschlüsse mit dem Keramiksubstrat gewährleistet und gleichzeitig einen geringeren Platzbedarf für die Last- und/oder Steueranschlüsse erfordert.

US-A-5876859 beschreibt ein Direct-Copper-Bonding-Substrat, dessen Metallisierung eine senkrechte Lasche aufweist, die seitlich mit einer Leiterplatte elektrisch verbunden ist.

Erfindungsgemäß wird diese Aufgabe durch ein Leistungshalbleitermodul der eingangs genannten Art gelöst, welches dadurch gekennzeichnet ist, daß zumindest ein Teil der strukturierten Metallisierung von dem Keramiksubstrat abgelöst ist und zu einer Greiflasche senkrecht hoch gebogen ist und daß die Greiflasche direkt mit einem Anschlußelement für äußere Anschlüsse verbunden ist.

Bei dieser Vorgehensweise werden aus der Metallisierung der Keramiksubstrate an den erforderlichen Anschlußstellen Teile der Metallisierung abgelöst und senkrecht nach oben gebogen. An diese innerhalb der Keramiksubstrate entstandenen Greiflaschen werden die nach außen gehenden Last- und/oder Steueranschlüsse befestigt. Typischerweise werden die Greiflaschen mit den Anschlußelementen durch eine Hartlötverbindung oder eine Schweißverbindung verbunden, so daß eine wesentlich festere und mechanisch zuverlässigere Verbindung hergestellt werden kann. Bei den bisher im Stand der Technik hergestellten Weichlotverbindungen konnte keine einer Hartlöt- bzw. einer Schweißverbindung gleichkommenden Festigkeit erzielt werden.

Durch diese Maßnahme kann eine zuverlässige temperaturbeständige Verbindung zwischen der Metallisierung auf dem Keramiksubstrat und den Anschlußelementen hergestellt werden, insbesondere bei der Verbindung über eine Schweißverbindung ist auch kein Zusatzwerkstoff erforderlich. Dadurch können die Montagezeiten sehr stark verkürzt werden.

Des Weiteren können durch diese Maßnahmen die Leistungshalbleitermodule weiter miniaturisiert werden, da Ausgleichsbögen in den Last- und/oder Steueranschlüssen entfallen können.

Des Weiteren können relativ kurze Lastanschlüsse mit großem Leitungsquerschnitt verwirklicht werden. Solche Lastanschlüsse weisen einen gegenüber den Lastanschlüssen nach dem Stand der Technik deutlich geringeren elektrischen Widerstand auf.

Schließlich kommt es durch die Maßnahmen gemäß der vorliegenden Erfindung zu keinen Isolationsproblemen, die darauf beruhen, daß Teile der Keramiksubstrate ausbrechen. Das Ausbrechen der Keramiksubstrate entsteht durch überhöhte Kerbwirkung unterhalb massiver Materialanhäufungen von Anschlußelementen bei Temperaturlastwechseln.

Insgesamt können nach der vorliegenden Erfindung Leistungshalbleitermodule gefertigt werden, die gegenüber dem Stand der Technik wesentlich zuverlässiger sind und kleinere Abmessungen aufweisen.

Eine ausführliche Beschreibung der Erfindung erfolgt anhand von in der Zeichnung dargestellten Ausführungsbeispielen. Es zeigen:
- Figur 1: eine Draufsicht auf ein Leistungshalbleitermodul, wobei der Gehäusedeckel entfernt ist,
- Figur 2: eine Seitenansicht des Leistungshalbleitermoduls in der in Figur 1 eingetragenen Schnittebene A-B gemäß dem Stand der Technik,
- Figur 3: eine Seitenansicht des Leistungshalbleitermoduls in der in Figur 1 eingetragenen Schnittebene A-B mit senkrecht nach oben gebogenen Greiflaschen,
- Figur 4: einen vergrößerten Ausschnitt aus der Figur 2 gemäß des mit X bezeichneten Bereichs und
- Figur 5: einen vergrößerten Ausschnitt aus der Figur 3 gemäß des mit Y bezeichneten Bereichs.

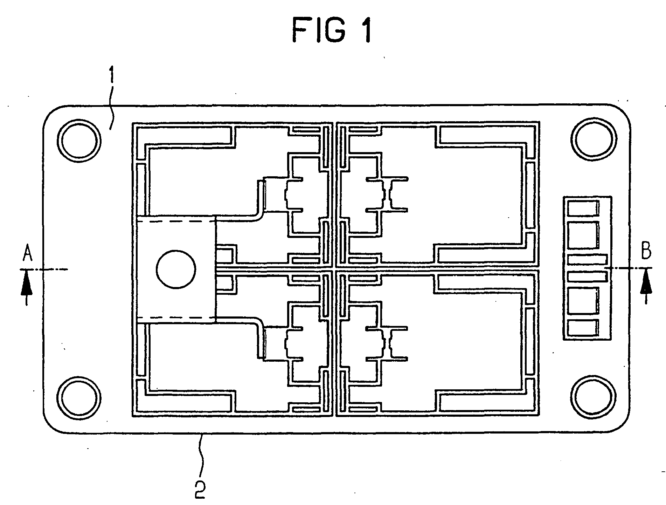

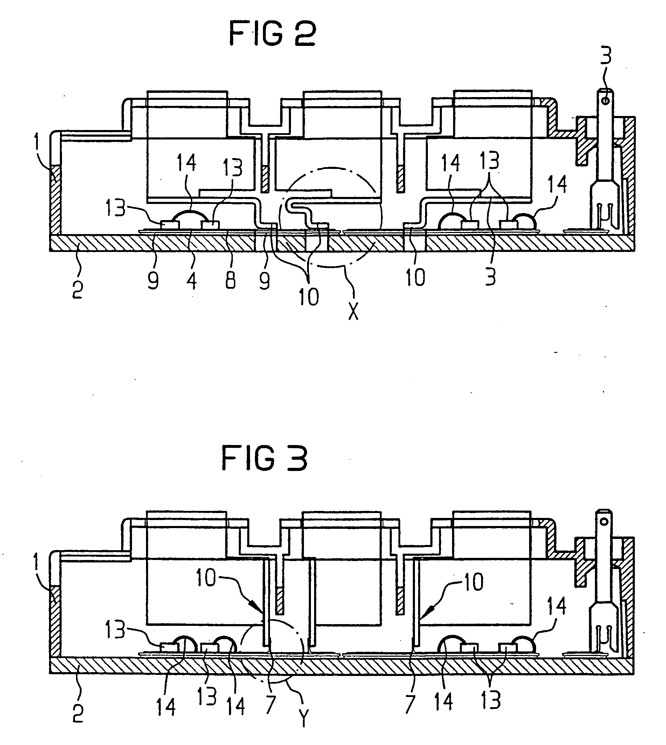

Figur 1 zeigt in Draufsicht ein Leistungshalbleitermodul, dessen Gehäusedeckel abgenommen ist. Das Leistungshalbleitermodul besteht aus einem Kunststoffgehäuse 1 und einer metallischen Bodenplatte 2, die in eine Öffnung am Boden des Kunststoffgehäuses 1 eingesetzt ist. Dies ist auch aus den Figuren 2 und 3 deutlicher zu ersehen. Die Figuren 2 und 3 zeigen Seitenansichten, in der in Figur 1 eingetragenen Schnittebene A-B.

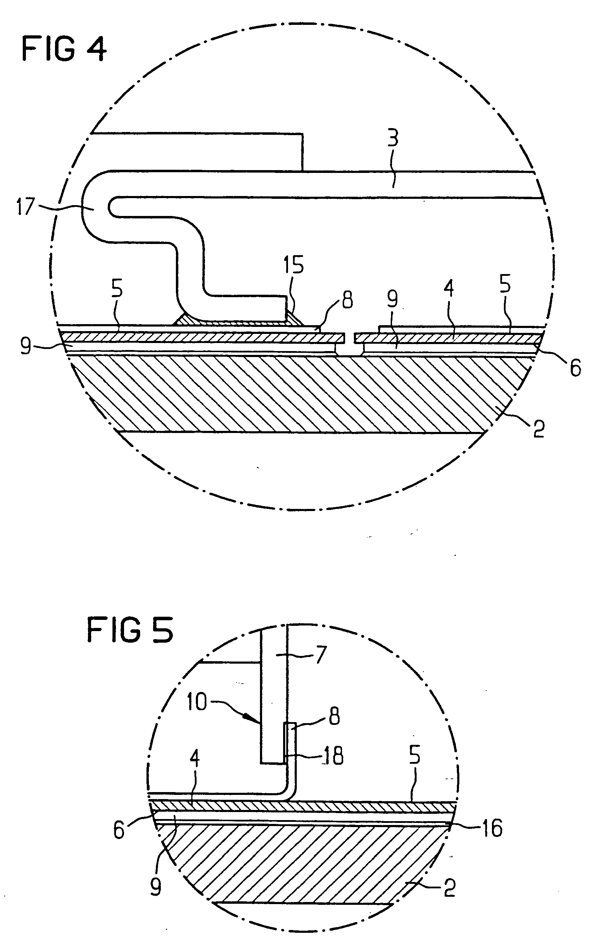

Das Leistungshalbleitermodul enthält mehrere Keramiksubstrate 4, die auf die metallische Bodenplatte 2 aufgebracht sind. Die Keramiksubstrate 4 bestehen hier aus Aluminiumoxid Al₂O₃ und weisen auf ihrer Unterseite 6 eine durchgehende Metallschicht 9 auf. Die Keramiksubstrate 4 sind über diese Metallschicht 9 mit der Oberseite 7 der metallischen Bodenplatte 2 über eine Weichlotverbindung 16 verbunden, was insbesondere aus den Figuren 4 und 5 zu ersehen ist. Auf der Oberseite 5 der Keramiksubstrate 4 befindet sich ebenfalls eine Metallisierung 8, die strukturiert ist und aus einer im Direct-Copper-Bonding-Verfahren hergestellten Kupferfolie besteht. Auf dieser strukturierten Metallisierung 8 befinden sich Halbleiterbauelemente 13. Die Halbleiterbauelemente 13 sind mit der Metallisierung 8 verlötet. Die Halbleiterbauelemente 13 und die strukturierte Metallisierung 8 sind zusätzlich über mit Drahtbondern hergestellten Bondverbindungen 14 miteinander verbunden.

Ferner sind auf der Oberseite 5 der Keramiksubstrate Verbindungselemente 3 angeordnet, die in den Figuren 2 und 4 die Gestalt von Blechstreifen aufweisen, die mit Ausgleichsbögen versehen sind. Die Anschlußpunkte der Anschlußelemente sind in der Figur 1 auf der Metallisierung 8 zu erkennen. Die Anschlußelemente gemäß dem Stand der Technik werden auf diesen Anschlußpunkten über eine Weichlotverbindung 15 aufgebracht.

Die Figur 2 und die Figur 4 zeigen Anschlußelemente 3, die z. B. aus einem etwa 1 mm dicken und etwa 3 mm breiten Metallstreifen bestehen, der beispielsweise aus Kupfer hergestellt ist. Dieser Metallstreifen weist einen Dehnungsbogen 17 auf.

Gemäß der vorliegenden Erfindung werden diese Anschlußelemente 3 mit Dehnungsbogen 17 dadurch ersetzt, daß die Metallisierung 8 auf der Oberseite 5 der Keramiksubstrate 4 im Bereich der Ecken der Keramiksubstrate senkrecht zu einer Greiflasche 10 nach oben gebogen ist und an den Enden der nach oben gebogenen Metallisierungsenden Anschlußelemente 7 ohne Dehnungsbögen über eine Hartlotverbindung 18 oder eine Schweißverbindung direkt verbunden werden, was in der Figur 3 und der Figur 5 dargestellt ist.

Wie der Figur 5 zu entnehmen ist, weist sowohl die Verbindungssstelle als auch die Anschlußelemente selber einen geringeren Platzbedarf auf. Da die Verbindungsstellen nicht mehr Weichlotverbindungen sondern Hartlot- oder Schweißverbindungen sind, wird eine weitaus bessere Stabilität gegenüber thermischen Wechselbelastungen gewährleistet. Die Greiflaschen können entweder mechanisch über ein Ablösewerkzeug von den Keramiksubstraten abgelöst werden, wobei eine lokale Unterätzung der Metallisierungskanten an der Ablösestelle den Ablösevorgang begünstigt.

In einer alternativen Vorgehensweise kann die Metallisierung durch eine lokale Wärmebehandlung vorgenommen werden. Dabei ist vorstellbar, daß mit einem Laser in einer Inertgasatmosphäre die Metallisierung von dem Keramiksubstrat gelöst wird.

In einer dritten Vorgehensweise werden von vorn herein die aufzubiegenden Teile der Metallisierung nicht auf das Keramiksubstrat gelötet, indem für die entsprechenden Teilflächen auf dem Keramiksubstrat kein Lot aufgebracht wird. Diese Vorgehensweise ist insbesondere bei Aluminiumnitrid-Keramiksubstraten vorteilhaft, da die Metallisierung derzeit dort nicht nachträglich abgelöst werden kann.

## Patentansprüche

1. Leistungshalbleitermodul bestehend aus:
- einem Kunststoffgehäuse (1) mit einer Bodenöffnung,
- mehreren Anschlußelementen (7) für äußere Haupt- und Steueranschlüsse,
- zumindest einem Keramiksubstrat (4), das zumindest auf seiner Oberseite (5) mit einer strukturierten Metallisierung (8) versehen und mit Halbleiterbauelementen (13) bestückt ist und in die Bodenöffnung des Kunststoffgehäuses (1) eingesetzt ist,
**dadurch gekennzeichnet,**
- **daß** zumindest ein Teil der strukturierten Metallisierung (8) von dem Keramiksubstrat (4) abgelöst ist und zu einer Greiflasche (10) senkrecht hochgebogen ist und
- **daß** die Greiflasche direkt mit einem Anschlußelement (7) für äu-ßere Anschlüsse verbunden ist.

2. Leistungshalbleiterbauelement nach Anspruch 1,
**dadurch gekennzeichnet,**
**daß** die Greiflasche (10) mit einem Anschlußelement (7) durch eine Hartlötverbindung (18) verbunden ist.

3. Leistungshalbleitermodul nach Anspruch 1,
**dadurch gekennzeichnet,**
**daß** die Greiflasche (10) mit einem Anschlußelement (7) durch eine Schweißverbindung verbunden ist.

4. Leistungshalbleitermodul nach einem der Ansprüche 1 bis 3,
**dadurch gekennzeichnet,**
**daß** als Keramiksubstrat (4) Aluminiumoxid A₂O₃ vorgesehen ist.

5. Leistungshalbleitermodul nach einem der Ansprüche 1 bis 3,
**dadurch gekennzeichnet,**
**daß** als Keramiksubstrat (4) Aluminiumnitrid AlN vorgesehen ist.

6. Leistungshalbleitermodul nach einem der Ansprüche 1 bis 5,
**dadurch gekennzeichnet,**
**daß** als strukturierte Metallisierung (8) Kupfer vorgesehen ist.

7. Leistungshalbleitermodul nach einem der Ansprüche 1 bis 5,
**dadurch gekennzeichnet,**
**daß** die strukturierte Metallisierung (8) auf ihrer Oberfläche mit einer Nickelschicht versehen ist.

8. Leistungshalbleitermodul nach einem der Ansprüche 1 bis 7,
**dadurch gekennzeichnet,**
**daß** das Kunststoffgehäuse (1) aus einem Rahmen und einem Dekkel besteht.

9. Leistungshalbleitermodul nach einem der Ansprüche 1 bis 8,
**dadurch gekennzeichnet,**
**daß** der Deckel Öffnungen aufweist, durch die zumindest ein Teil der Anschlußelemente durchgeführt wird.

## Claims

1. Power semiconductor module, comprising:
- a plastic housing (1) with a bottom opening,
- a plurality of connection elements (7) for external main and control connections,
- at least one ceramic substrate (4), which at least on its upper side (5) is provided with a structured metallization (8) and is fitted with semiconductor components (13) and is inserted into the bottom opening of the plastic housing (1),
**characterized**
- **in that** at least a part of the structured metallization (8) has been detached from the ceramic substrate (4) and has been bent vertically upwards to form a grip tab (10), and
- **in that** the grip tab is directly joined to a connection element (7) for external connections.

2. Power semiconductor component according to Claim 1, **characterized in that** the grip tab (10) is joined to a connection element (7) by a brazed joint (18).

3. Power semiconductor module according to Claim 1, **characterized in that** the grip tab (10) is joined to a connection element (7) by means of a welded joint.

4. Power semiconductor module according to one of Claims 1 to 3, **characterized in that** aluminium oxide Al₂O₃ is provided as the ceramic substrate (4).

5. Power semiconductor module according to one of Claims 1 to 3, **characterized in that** aluminium nitride AlN is provided as the ceramic substrate (4).

6. Power semiconductor module according to one of Claims 1 to 5, **characterized in that** copper is provided as the structured metallization (8).

7. Power semiconductor module according to one of Claims 1 to 5, **characterized in that** the structured metallization (8) is provided with a layer of nickel on its surface.

8. Power semiconductor module according to one of Claims 1 to 7, **characterized in that** the plastic housing (1) comprises a frame and a cover.

9. Power semiconductor module according to one of Claims 1 to 8, **characterized in that** the cover has openings, through which at least some of the connection elements are guided.

## Revendications

1. Module à semi-conducteur de puissance composé de :
- un boîtier en plastique (1) doté d'une ouverture de fond,
- de plusieurs éléments de connexion (7) pour des connexions extérieures principale et de commande,
- au moins un substrat en céramique (4) pourvu au moins sur sa face supérieure (5) d'une métallisation structurée (8) et équipé d'éléments de construction semi-conducteurs (13) et introduit dans l'ouverture de fond du boîtier en plastique (1),
**caractérisé en ce qu'**
- au moins une partie de la métallisation structurée (8) est détachée du substrat en céramique (4) et est courbée vers le haut à la verticale en une patte de préhension (10), et
- la patte de préhension est reliée à un élément de connexion (7) pour des connexions extérieures.

2. Elément de construction semi-conducteur selon la revendication 1,
**caractérisé en ce que**
la patte de préhension (10) est reliée à un élément de raccordement (7) par une connexion par brasage fort (18).

3. Module à semi-conducteur de puissance selon la revendication 1,
**caractérisé en ce que**
la patte de préhension (10) est reliée à un élément de raccordement (7) par une connexion soudée.

4. Module à semi-conducteur de puissance selon l'une quelconque des revendications 1 à 3,
**caractérisé en ce que**
le substrat en céramique (4) est en oxyde d'aluminium Al₂Ol₃.

5. Module à semi-conducteur de puissance selon l'une quelconque des revendications 1 à 3,
**caractérisé en ce que**
le substrat en céramique (4) est en nitrure d'aluminium AIN.

6. Module à semi-conducteur de puissance selon l'une quelconque des revendications 1 à 5,
**caractérisé en ce que**
la métallisation structurée est en cuivre.

7. Module à semi-conducteur de puissance selon l'une quelconque des revendications 1 à 5,
**caractérisé en ce que**
la métallisation structurée (8) est pourvue à sa surface d'une couche de nickel.

8. Module à semi-conducteur de puissance selon l'une quelconque des revendications 1 à 7,
**caractérisé en ce que**
le boîtier en plastique (1) se compose d'un cadre et d'un couvercle.

9. Module à semi-conducteur de puissance selon l'une quelconque des revendications 1 à 8,
**caractérisé en ce que**
le couvercle présente des ouvertures traversées par au moins une partie des éléments de connexion.
